# EUROPEAN PATENT APPLICATION

(11) **EP 3 982 409 A1**
(43) Date of publication of application: **13.04.2022**
(21) Application number: 19932023.5
(22) Date of filing: 24.12.2019
(51) Int. Cl.: H01L 27/108

(54) **MEMORY STRUCTURE, AND METHOD FOR FORMING SAME**

(30) Priority: 04.06.2019 CN 201910480732
(71) Applicant: Changxin Memory Technologies, Inc., 230000 Hefei City, Anhui (CN)
(72) Inventor: JIANG, Wen-yong, Hefei City, Anhui 230000 (CN)
(74) Representative: Lavoix
(86) International application number: PCT/CN2019/127856
(87) International publication number: WO 2020/244198

(57) **Abstract**

Disclosed are a memory structure and its formation method. The memory structure includes: a semiconductor substrate, wherein a number of discrete active regions arranged in rows and columns are formed on the semiconductor substrate, and a first groove is provided between the adjacent active regions and filled with an insulating layer; two second grooves along a row direction in each active region, wherein the two second grooves divide each active region into a drain located in a middle of the active region and two sources located on both sides of the drain; a third groove located in part of the insulating layer on both sides of a bottom of the second groove, wherein the third groove exposes at least part of surfaces of both sidewalls of the active region at the bottom of the second groove, and is contact with the corresponding second groove, and the two third grooves adjacent in the row direction are not contacted; and a gate structure located in the second groove and the third groove. The memory structure reduces a leakage current.

## Description

### TECHNICAL FIELD

The present invention relates to the field of memories, in particular to a memory structure and its formation method.

### BACKGROUND

A Dynamic Random Access Memory (DRAM) is a semiconductor memory device commonly used in computers and composed of many repeated memory cells. Each memory cell is usually composed of a capacitor and a transistor. The transistor has its gate connected to a wordline, its drain connected to a bitline and its source connected to the capacitor. A voltage signal on the wordline can control on or off of the transistor, and then, data information stored in the capacitor can be read through the bitline or data information can be written into the capacitor through the bitline for storage.

However, a memory structure composed of the capacitor and the transistor in the existing memory has current leakage problem, and a performance of the existing memory is expected to be further improved.

### SUMMARY

The present invention is intended to solve the technical problem of reducing a leakage current of a memory structure composed of a capacitor and a transistor in an existing memory.

To this end, the present invention provides a formation method of a memory structure, which includes:
providing a semiconductor substrate, on which a number of discrete active regions arranged in rows and columns are formed, a first groove being provided between the adjacent active regions and filled with an insulating layer;
etching the active regions to form two second grooves along a row direction in each active region, the two second grooves dividing each active region into a drain located in a middle of the active region and two sources located on both sides of the drain;
etching away part of the insulating layer on both sides of a bottom of the second groove to form a third groove in the insulating layer, the third groove exposing at least part of surfaces of both sidewalls of the active region at the bottom of the second groove, the third groove being contact with the corresponding second groove, and the two third grooves adjacent in the row direction being not contacted; and
forming a gate structure in the second groove and the third groove.

Optionally, an anti-etching dielectric layer is formed on the sidewalls of the active region between the two second grooves and in the insulating layer, and the anti-etching dielectric layer is made of a material different from that of the insulating layer.

Optionally, a depth of the anti-etching dielectric layer is greater than a total depth of the third groove and the second groove; and width of the anti-etching dielectric layer in a column direction is greater than a width of the third groove in the column direction.

Optionally, a formation process of the anti-etching dielectric layer includes: forming a mask layer on the insulating layer and the active region, wherein the mask layer comprises a number of openings along the row direction, and each opening exposes at least part of the surface of the insulating layer on both sides of the active region; etching the insulating layer along the openings by using the mask layer as a mask to form a fourth groove in the insulating layer, wherein the fourth groove exposes part of the sidewall of the active region; and forming the anti-etching dielectric layer filling the fourth groove.

Optionally, before the step of etching away part of the insulating layer on both sides of a bottom of the second groove to form a third groove in the insulating layer, a protective spacer is formed on the sidewall of the second groove.

Optionally, the specific process of forming a number of discrete active regions arranged in rows and columns on the semiconductor substrate includes: forming a number of discrete elongated active regions arranged in the column direction on the semiconductor substrate, a first trench being provided between adjacent elongated active regions and filled with a first isolation layer; etching the elongated active regions and the first isolation layer to form a number of second trenches arranged in the row direction in the elongated active regions and the first isolation layer, the second trench disconnecting the elongated active regions to form the number of discrete active regions arranged in rows and columns and the first groove being formed by the first trench and the second trench.

Optionally, a second isolation layer filling the second trench is formed, and the insulating layer is formed by the first isolation layer and the second isolation layer.

Optionally, the elongated active region and the first isolation layer at a bottom of the second trench are etched to form a third trench in the elongated active region and the first isolation layer at the bottom of the second trench before formation of the second isolation layer, and a size of the third trench in the row direction is greater than a size of the second trench in the row direction; the second isolation layer is formed in the third trench and the second trench.

Optionally, a depth of the second trench or a total depth of the second trench and the third trench is greater than the total depth of the second groove and the third groove.

Optionally, the third groove only exposes part of the surfaces of the two sidewalls of the active region at the bottom of the second groove.

Optionally, in addition to exposing part of the surfaces of the two sidewalls of the active region at the bottom of the second groove, the third groove exposes part of a surface of a sidewall of the second trench or the third trench, or part of the surface of one sidewall of the active region apart from the second groove.

Optionally, the gate structure is composed of: a gate dielectric layer located on the surfaces of the sidewalls of the second groove and the third groove; and a gate located on the gate dielectric layer and filling the second groove and the third groove.

Optionally, the formation method also includes: forming a wordline connected to the gate; forming a capacitor connected to the source on the insulating layer; and forming a bitline connected to the drain on the insulating layer.

The present invention also provides a memory structure, which is composed of:
a semiconductor substrate, wherein a number of discrete active regions arranged in rows and columns are formed on the semiconductor substrate, and a first groove is provided between the adjacent active regions and filled with an insulating layer;
two second grooves along a row direction in each active region, wherein the two second grooves divide each active region into a drain located in a middle of the active region and two sources located on both sides of the drain;
a third groove located in part of the insulating layer on both sides of a bottom of the second groove, wherein the third groove exposes at least part of surfaces of both sidewalls of the active region at the bottom of the second groove, and is contact with the corresponding second groove, and the two third grooves adjacent in the row direction are not contacted; and
a gate structure located in the second groove and the third groove.

Optionally, an anti-etching dielectric layer is formed on the sidewalls of the active region between the two second grooves and in the insulating layer, and the anti-etching dielectric layer is made of a material different from that of the insulating layer.

Optionally, a depth of the anti-etching dielectric layer is greater than a total depth of the third groove and the second groove, and a width of the anti-etching dielectric layer in the column direction is greater than a width of the third groove in the column direction.

Optionally, a protective spacer is formed on the sidewall of the second groove.

Optionally, the first groove includes first trenches arranged in the column direction and second trenches arranged in the row direction, the first trench is filled with a first isolation layer, and the second trench is filled with a second isolation layer.

Optionally, a third trench is formed at a bottom of the second trench, a size of the third trench in the row direction is greater than a size of the second trench in the row direction, and the third trench and the second trench are filled with the second isolation layer.

Optionally, a depth of the second trench or a total depth of the second trench and the third trench is greater than the total depth of the second groove and the third groove.

Optionally, the third groove only exposes part of the surfaces of the two sidewalls of the active region at the bottom of the second groove.

Optionally, in addition to exposing part of the surfaces of the two sidewalls of the active region at the bottom of the second groove, the third groove exposes part of a surface of a sidewall of the second trench or the third trench, or part of the surface of one sidewall of the active region apart from the second groove.

Optionally, the gate structure includes: a gate dielectric layer located on the surfaces of the sidewalls of the second groove and the third groove; and a gate located on the gate dielectric layer and filling the second groove and the third groove.

Optionally, the memory structure also includes: a wordline connected to the gate; a capacitor located on the insulating layer and connected to the source; and a bitline located on the insulating layer and connected to the drain.

Compared with the prior art, the technical solutions proposed in the present invention have the following advantages.

The formation method of a memory structure according to the present invention includes: etching the active regions to form the two second grooves along the row direction in each active region, the two second grooves dividing each active region into the drain located in the middle of the active region and the two sources located on both sides of the drain; then etching away part of the insulating layer on both sides of the bottom of the second groove to form a third groove in the insulating layer, the third groove exposing at least part of the surfaces of both sidewalls of the active region at the bottom of the second groove, the third groove being contact with the corresponding second groove, and the two third grooves adjacent in the row direction being not contacted; and forming the gate structure in the second groove and the third groove. By forming the aforementioned third groove structure, when formed in the third groove and the second groove, the gate structure at least covers at least three side surfaces of the active region (channel region) between the source and the drain, which increases an area of the gate structure, improves control of the gate structure over the channel region and limits a leakage path of the leakage current between a polar plate of the capacitor (the capacitor is configured to store data and has one polar plate electrically connected to the source) and the semiconductor substrate, thereby effectively reducing the leakage current, increasing an area of the wordline (the gate structure includes the wordline) and lowering a resistance value of the wordline.

Furthermore, in addition to exposing part of the surfaces of the two sidewalls of the active region at the bottom of the second groove, the third groove exposes part (a position corresponding to the second isolation layer) of the surface of the sidewall of the second trench or the third trench, or part of the surface of one sidewall of the active region apart from the second groove. With such a third groove structure, after formed in the third groove and the second groove, the gate structure surrounds the peripheral sidewalls of the active region (channel region) between the source and the drain, which increases the area of the gate structure, improves the control of the gate structure over the channel region and further limits the leakage path of the leakage current between the polar plate of the capacitor (the capacitor is configured to store data and has one polar plate electrically connected to the source) and the semiconductor substrate, thereby more effectively reducing the leakage current, increasing the area of the wordline (the gate structure includes the wordline) and lowering the resistance value of the wordline.

Furthermore, the anti-etching dielectric layer is formed on the sidewalls of the active region between the two second grooves and in the insulating layer, made of a material different from that of the insulating layer, and when part of the insulating layer on both sides of the bottom of the second groove is subsequently etched away to form, in the insulating layer, the third groove which exposes at least part of the surface of the two sidewalls of the active region at the bottom of the second groove, the anti-etching dielectric layer prevents contact between the adjacent second grooves or the adjacent third grooves, so as to form two independent wordlines (gate structures) subsequently.

Furthermore, before the step of etching away part of the insulating layer on both sides of a bottom of the second groove to form a third groove in the insulating layer, the protective spacer is formed on the sidewall of the second groove. When part of the insulating layer on both sides of the bottom is etched away subsequently, the protective spacer protects the source and the drain on both sides of the sidewall of the second groove from damage caused by etching, and prevents a feature size of a window of the second groove from being changed.

The memory structure according to the present invention is composed of the two second grooves along the row direction in each active region, wherein the two second grooves divide each active region into the drain located in the middle of the active region and two sources located on both sides of the drain; the third groove located in part of the insulating layer on both sides of the bottom of the second groove, wherein the third groove exposes at least part of the surface of both sidewalls of the active region at the bottom of the second groove, and is contact with the corresponding second groove, and the two third grooves adjacent in the row direction are not contacted; and the gate structure located in the second groove and the third groove. The gate structure at least covers at least three side surfaces of the active region (channel region) between the source and the drain, which increases the area of the gate structure, improves the control of the gate structure over the channel region and limits the leakage path of the leakage current between the polar plate of the capacitor (the capacitor is configured to store data and has one polar plate electrically connected to the source) and the semiconductor substrate, thereby effectively reducing the leakage current, increasing the area of the wordline (the gate structure includes the wordline) and lowering the resistance value of the wordline.

### BRIEF DESCRIPTION OF THE DRAWINGS

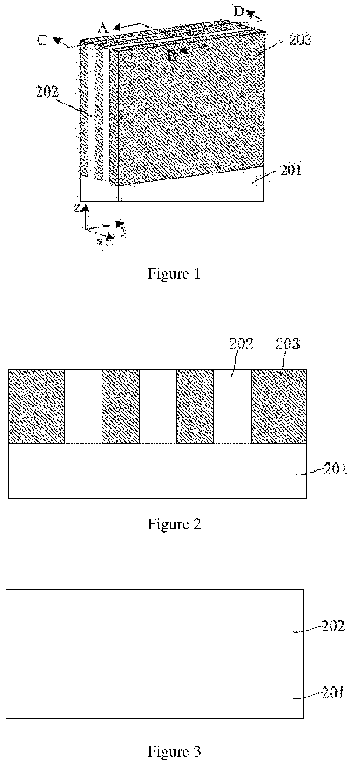

Figures. 1 to 28 are schematic structural diagrams of a formation process of a memory structure according to embodiments of the present invention.

### DETAILED DESCRIPTION

As described in the background, an existing memory structure has a current leakage problem, and a performance of a memory is expected to be further improved.

According to a study, in a prior art, a trench-type transistor structure is usually used to reduce a leakage current in a memory capacitor in a DRAM and increase an off-resistance of a transistor. The trench-type transistor structure comprises a semiconductor substrate, a trench located in the semiconductor substrate, a gate located in the trench, and a drain region and a source region located in the semiconductor substrate on both sides of the trench. The trench-type transistor has its gate connected to a wordline, its drain region connected to a bitline and its source region connected to a capacitor. Since some electrons will leak from the source region into the semiconductor substrate when the transistor is turned off, a storage capacity of the DRAM is decreased, and therefore, how to reduce the leakage current in the memory structure has become an urgent problem to be solved.

To this end, the present invention provides a memory structure and its formation method. The formation method of a memory structure includes: etching active regions to form two second grooves along a row direction in each active region, the two second grooves dividing each active region into a drain located in a middle of the active region and two sources located on both sides of the drain; then etching away part of an insulating layer on both sides of a bottom of the second groove to form, in the insulating layer, a third groove exposing at least part of surfaces of both sidewalls of the active region at the bottom of the second groove, the third groove being contact with the corresponding second groove, and the two third grooves adjacent in the row direction being not contacted; and forming a gate structure in the second groove and the third groove. By forming the aforementioned third groove structure, when formed in the third groove and the second groove, the gate structure at least covers at least three side surfaces of the active region (channel region) between the source and the drain, which increases an area of the gate structure, improves control of the gate structure over the channel region and limits a leakage path of the leakage current between a polar plate of a capacitor (the capacitor is configured to store data and has one polar plate electrically connected to the source) and a semiconductor substrate, thereby effectively reducing the leakage current, increasing an area of a wordline (the gate structure includes the wordline) and lowering a resistance value of the wordline.

To make the foregoing objectives, features, and advantages of the present disclosure more apparent and lucid, various embodiments are described in detail below with reference to the accompanying drawings. When describing the embodiments herein, for the convenience of description, a schematic diagram may be partially enlarged not according to a general scale, and the schematic diagram is only an example, and should not limit the protection scope of the present invention herein. In addition, three-dimensional dimensions (length, width and depth) should be included in actual production.

Figures. 1 to 28 are schematic structural diagrams of a formation process of a memory structure according to embodiments of the present invention.

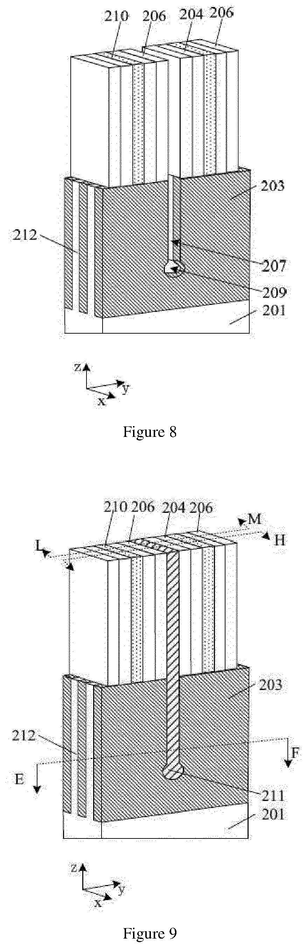

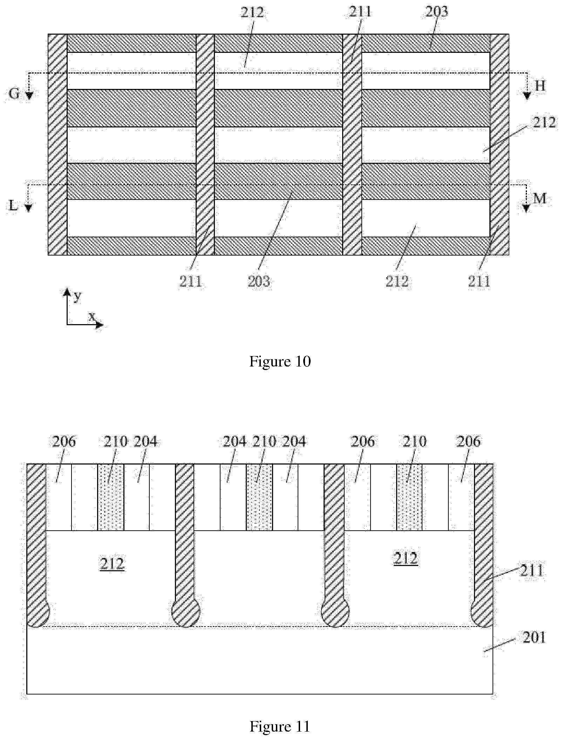

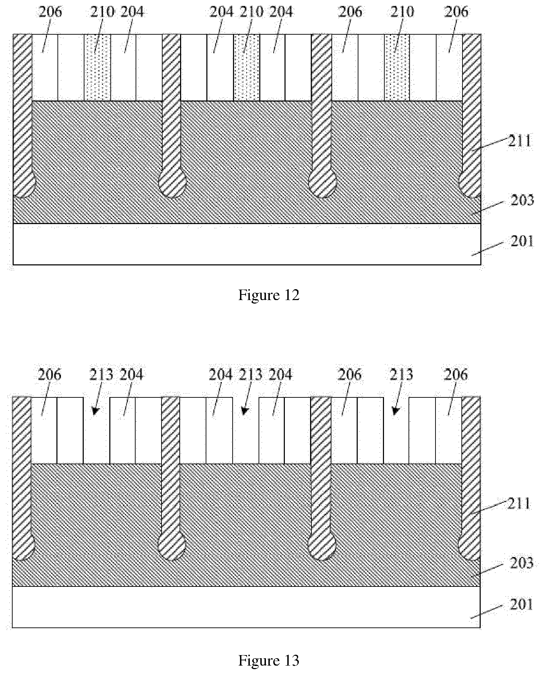

Referring to Figures 9 to 12, Figure 10 is a schematic sectional structural diagram taken along cutting line EF in Figure 9; Figure 11 is a schematic sectional structural diagram taken along cutting line GH in Figure 9; and Figure 12 is a schematic sectional structural diagram taken along cutting line LM in Figure 9. A semiconductor substrate 201 is provided, on which a number of discrete active regions 212arranged in rows and columns are formed. A first groove is provided between the adjacent active regions 212, and filled with an insulating layer.

The number of discrete active regions 212may be formed by etching the semiconductor substrate 201 or by using an epitaxial process.

In this embodiment, the active region 212 is formed by etching the semiconductor substrate 201, and a formation process of the active region 212 will be described in detail below with reference to the accompanying drawings (Figures 1 to 12), and includes the following steps.

Referring to Figures 1 to 3, with Figure 2 being a schematic sectional structural diagram taken along cutting line AB in Figure 1,and Figure3 being a schematic sectional structural diagram taken along cutting line CD in Figure 1,the semiconductor substrate 201 is provided, a number of discrete elongated active regions 202arranged in a column direction are formed on the semiconductor substrate 201,and a first trench is provided between the adjacent elongated active regions 212, and filled with a first isolation layer 203.

The semiconductor substrate 201may be made of silicon (Si), germanium (Ge), silicon germanium (GeSi), silicon carbide (SiC), silicon-on-insulator (SOT), germanium-on-insulator (GOT), or other materials, such as gallium arsenide and other group III-V compounds. In this embodiment, a silicon substrate is used as the semiconductor substrate 201, and the semiconductor substrate 201is doped with certain impurity ions as required, and the impurity ions may be N-type impurity ions or P-type impurity ions. In an embodiment, the doping includes doping in well regions and doping in source-drain regions.

The elongated active regions 202are subsequently configured to form the number of discrete active regions 212 (referring to Figures 9 to 12), and the first isolation layer 203 is subsequently configured for electrical isolation between the active regions 212. In an embodiment, the formation process of the elongated active regions 202and the first isolation layer 203 includes: forming a mask layer(not shown) on the semiconductor substrate 201, the mask layer having a number of openings arranged in parallel along the column direction; etching the semiconductor substrate 201 along the opening using the mask layer as a mask, and forming, in the semiconductor substrate 201, the number of discrete elongated active regions 202 arranged in the column direction, the first trench being provided between the adjacent elongated active regions 202; forming an isolation material layer in the first trench and on a surface of the mask layer, the isolation material layer filling the first trench; removing the isolation material layer and the mask layer on a surface of the elongated active region 202 by planarization, and forming the first isolation layer 203 in the first trench. It should be noted that the column direction in the present application refers to a direction parallel to the x-axis, and for convenience of illustration, the elongated active region 202 and the semiconductor substrate 201 are distinguished by a dotted line in Figures 2 and 3.

The first isolation layer 203 may be made of silicon oxide, silicon nitride, silicon oxynitride or other suitable isolation materials. In this embodiment, the first isolation layer 203 is made of silicon oxide.

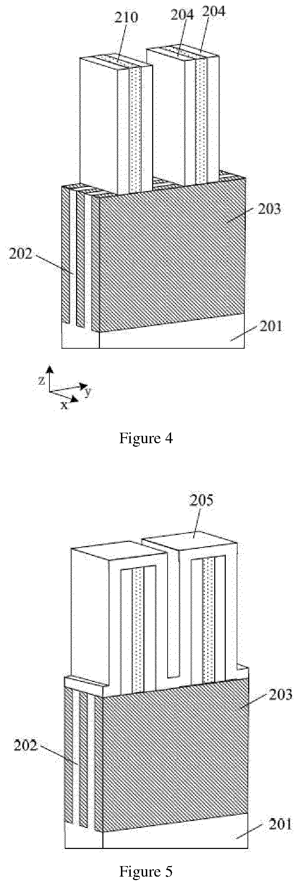

Referring to Figure 4, a number of first mask patterns 210 arranged along the row direction are formed on the elongated active region 202 and the first isolation layer 203; and a second mask pattern 204 is formed on two sidewalls of the first mask pattern 210.

The number of first mask patterns 210 are arranged in parallel along the row direction perpendicular to the column direction. In this embodiment, the row direction is parallel to the y-axis.

The position where a fourth groove is subsequently formed in the insulating layer corresponds to a position of the first mask pattern 210. Positions where the two second grooves distributed along the row direction are subsequently formed correspond to positions of the second mask patterns 204.

In this embodiment, the first mask pattern 210 and the second mask pattern 204 are made of different materials. In one embodiment, the first mask pattern 210 is made of silicon nitride, and the second mask pattern 204 is made of silicon oxynitride. In other embodiments, the first mask pattern 210 and the second mask pattern 204 can be also made of other suitable materials.

In one embodiment, the formation process of the second mask pattern 204 includes: forming a second mask material layer (not shown) on a surface of the first mask pattern 210 and surfaces of the elongated active region 202and the first isolation layer 203; etching the second mask material layer without a mask; and forming the second mask pattern 204 on two sidewalls of the first mask pattern 210.

In other embodiments, the first mask pattern may not be formed first, but the second mask pattern may be formed first on the elongated active region and the first isolation layer, and after the second mask pattern is formed, the first mask pattern and a third mask pattern may be subsequently formed simultaneously.

Referring to Figures 4 and 5, the third mask pattern 206 is formed on the surface of the sidewall of the second mask pattern 204.

In one embodiment, the formation process of the third mask pattern 206 includes: forming a third mask material layer 205 on the surfaces of the first mask pattern 210 and the second mask pattern 204and the surfaces of the elongated active region 202 and the first isolation layer 203; etching the third mask material layer 205 without a mask; and forming the third mask pattern 206 on the surface of the sidewall of the second mask pattern 204.

The third mask pattern 206 is used as a mask in a subsequent process of etching the elongated active region and the first isolation layer to form a number of second trenches arranged in the row direction in the elongated active region and the first isolation layer. The third mask pattern 206 may be made of amorphous carbon or any other suitable material.

In this embodiment, with respect to mask structures of the first mask pattern 210, the second mask pattern 204and the third mask pattern 206, the second mask pattern 204 and the third mask pattern 206are sequentially formed on the two sidewalls of the first mask pattern 210 in a self-aligned way, such that the first mask pattern 210, the second mask pattern 204 and the third mask pattern 206 have higher position accuracy and size accuracy, thus improving position and size accuracy of the second trench, the second groove and the fourth groove formed subsequently, and helping to improve the performance of the memory structure; a process of forming a mask using plural photoetching and etching operations is avoided, thus saving process steps.

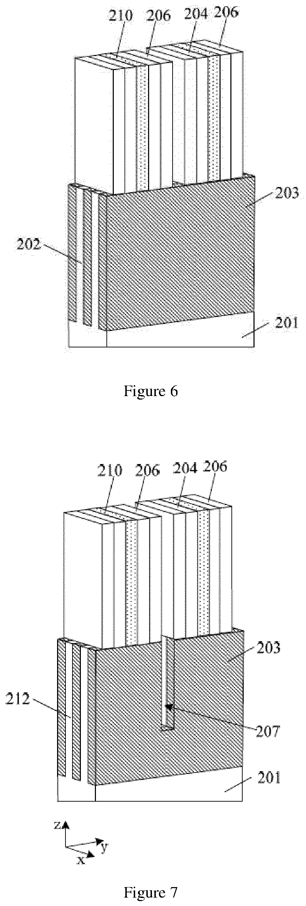

Referring to Figure 7, the elongated active region 202 (referring to Figure 6) and the first isolation layer 203 are etched to form a number of second trenches 207 arranged in the row direction in the elongated active region 202 and the first isolation layer 203, the elongated active regions 202 are disconnected by the second trenches 207 to form the number of discrete active regions 212 arranged in rows and columns; and the first trench and the second trench 207 constitute the first groove.

In this embodiment, the third mask pattern 206, the second mask pattern 204and the first mask pattern 210 are used as masks when the elongated active region 202 and the first isolation layer 203 are etched; and an anisotropic dry etching process may be adopted as the etching process, such as an anisotropic plasma etching process.

In this embodiment, referring to Figure 8, after the second trench 207 is formed, the elongated active region and the first isolation layer 203 at the bottom of the second trench 207 are further etched to form a third trench 209 in the elongated active region and the first isolation layer 203 at the bottom of the second trench 207, with a size of the third trench 209in the row direction greater than a size of the second trench 207 in the row direction.

An isotropic etching process is used in forming the third trench 209. In one embodiment, the isotropic etching process is a wet etching process.

In this embodiment, the size of the third trench 209 in the row direction being greater than the size of the second trench 207 in the row direction means that the size of the third trench 209 along the y-axis direction is greater than the size of the second trench 207 along the y-axis direction, and when a second isolation layer is formed subsequently, a bottom of the second isolation layer formed has a greater size, which reduces an area of a connection region between a subsequently formed source and the bottom semiconductor substrate, thereby reducing an area of a leakage path of a current in the source to the semiconductor substrate and thus a leakage current. It should be noted that the sizes of the third trench 209 and the second trench 207 refer to maximum sizes of the third trench 209 and the second trench 207 in the y-axis direction.

It should be noted that in other embodiments, the third trench may not be formed, and the second isolation layer may be directly formed in the second trench subsequently.

A depth of the second trench 207 or a total depth of the second trench 207 and the third trench 209is greater than a total depth of the second groove and a third groove formed subsequently. When subsequently formed in the second trench 207 or the second trench 207 and the third trench 209, the second isolation layer can well isolate the adjacent active regions and wordlines (gate structures).

Referring to Figures 9 to 12, the second isolation layer or a shallow trench isolation layer 211 is formed in the third trench and the second trench.

The second isolation layer or the shallow trench isolation layer 211 and the insulating layer 203 are configured to isolate the adjacent active regions 212, and the number of discrete active regions 212 are arranged in rows and columns on the semiconductor substrate (referring to Figure 10).

In this embodiment, the formed second isolation layer or shallow trench isolation layer 211 may be flush with a top surface of the first mask pattern 210, and be made of silicon oxide.

After formed, the second isolation layer or the shallow trench isolation layer 211 and the first isolation layer 203 constitute the insulating layer.

Referring to Figure 13 which is based on Figure 12, the first mask patterns 210are removed (referring to Figure 12) to form a number of openings (first openings) 213 distributed along the row direction, with each opening exposing at least part of the surface of the insulating layer (the first isolation layer 203) on both sides of the active region 212.

The first mask pattern 210may be removed using a wet etching process. Since the first mask pattern 210 is made of a different material from the second mask pattern 204, the third mask pattern 206and the second isolation layer 211, there are multiple flexible etching options. Therefore, when the first mask pattern 210 is removed, an etching rate of the first mask pattern 210 is greater than that of the second mask pattern 204, the third mask pattern 206 and the second isolation layer 211, as a result of which the second mask pattern 204, the third mask pattern 206 and the second isolation layer 211 are less etched or the amount of etching is basically negligible, and the second mask pattern 204, the third mask pattern 206 and the second isolation layer 211 are reserved as mask layers for etching the insulating layer (the first isolation layer 203) and forming the fourth groove in the insulating layer (the first isolation layer 203).

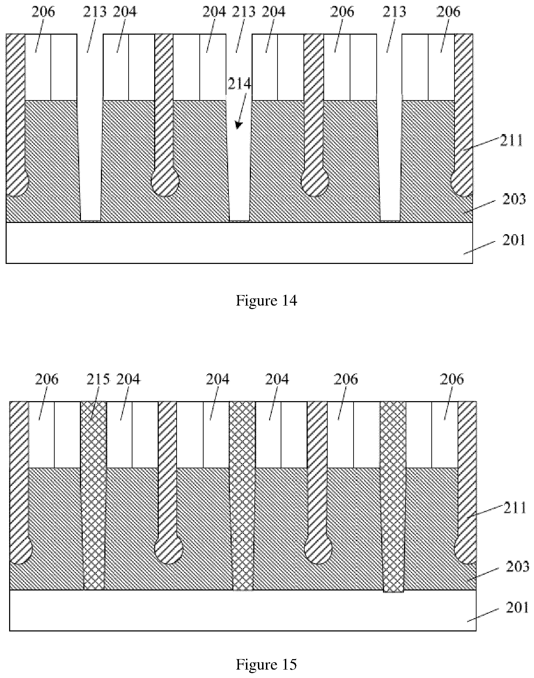

Referring to Figure 14, the insulating layer (the first isolation layer 203) is etched along the openings 213 to form the fourth groove 214 in the insulating layer (the first isolation layer 203) by using the mask layers (the second mask pattern 204, the third mask pattern 206 and the second isolation layer 211) as masks, with the fourth groove 214 exposing part of the sidewall of the active region.

A depth of the fourth groove 214 is greater than that of the second isolation layer 211.

Referring to Figure 15, an anti-etching dielectric layer 215 filling the fourth groove is formed.

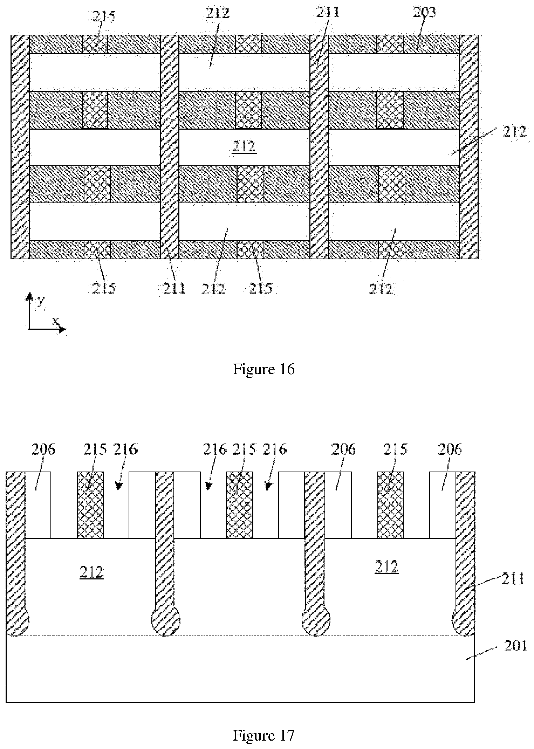

The formed anti-etching dielectric layer 215 is located on the sidewalls of the active region 212between the two second grooves formed subsequently and in the insulating layer 203(referring to Figure 16). The anti-etching dielectric layer 215 is made of a material different from that of the insulating layer, such as silicon nitride, silicon oxynitride or any other suitable material. In this embodiment, the anti-etching dielectric layer 215 is made of silicon nitride, and prevents contact between the adjacent second grooves or adjacent third grooves to form two independent wordlines (gate structures) subsequently when part of the insulating layer on both sides of the bottom of the second groove is subsequently etched away and when the third groove exposing at least part of the surfaces of the two sidewalls of the active region at the bottom of the second groove is formed in the insulating layer.

A depth of the anti-etching dielectric layer 215 is greater than the total depth of the third groove and the second groove formed subsequently, and a width of the anti-etching dielectric layer 215 in the column direction is greater than a width of the third groove in the column direction, so as to better prevent the contact between the adjacent second grooves or adjacent third grooves and reduce the difficulty in the process of forming the third groove when the third groove is formed subsequently.

In one embodiment, a formation process of the anti-etching dielectric layer 215 includes: forming an anti-etching dielectric material layer in the opening and the fourth groove and on the surfaces of the second mask pattern 204, the third mask pattern 206 and the second isolation layer 211, with the anti-etching dielectric material layer formed filling the opening and the fourth groove; removing the anti-etching dielectric material layer on top surfaces of the second mask pattern 204, the third mask pattern 206 and the second isolation layer 211 by planarization; and forming the anti-etching dielectric layer 215 in the openings and the fourth groove.

Referring to Figure 17 which is based on Figures 11 and 16 as well as Figure 18 which is based on Figure 15, the second mask pattern 204 (referring to Figure 15) is removed to form a number of openings (second openings) 216 arranged along the row direction, with each opening 216 exposing at least part of the surface of the active region 212.

There are two openings 216 on each active region 212. When the active region 212 is subsequently etched along the two openings 216, two second grooves distributed along the row direction can be formed in each active region 212, with the two second grooves dividing each active region 212 into a drain located in the middle and two sources located on both sides of the drain.

A wet etching process may be used to remove the second mask pattern 204.

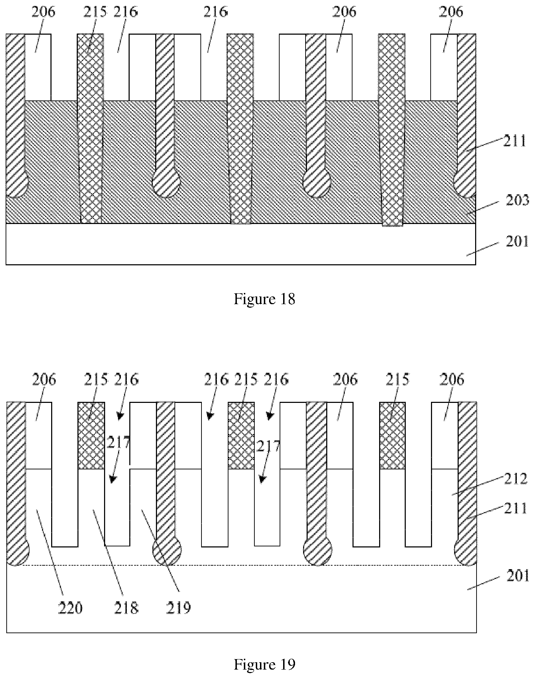

In this embodiment, referring to Figure 18, each opening 216 correspondingly exposes the surface of the insulating layer 203 at the bottom and the surface of the sidewall of the anti-etching dielectric layer 215.

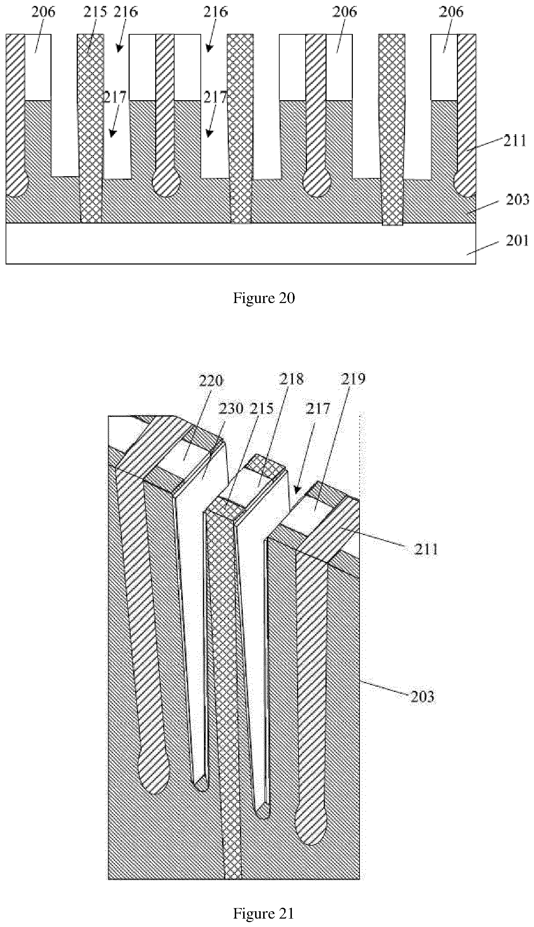

Referring to Figure 19 which is based on Figure 17 as well as Figure 20 which is based on Figure 18, the active region 212 is etched along the opening 216 to form two second grooves 217 distributed along the row direction in each active region 212, with the two second grooves 217 dividing each active region 212 into a drain 218 located in the middle and two sources 220 and 219 located on both sides of the drain 218.

In one embodiment, the active region 212 is etched using a plasma etching process in which HBr or/and C**I**₂is adopted.

In this embodiment, the formed two second grooves 217 are discrete, and divide each active region 212 into the drain 218 located in the middle and the two sources 220 and 219 located on both sides of the drain 218, and two common-drain trench-type transistors may be subsequently formed after the wordline (gate structure) is formed.

In other embodiments, after formed, the two second grooves 217 divide each active region 212 into a source located in the middle and two drains located on both sides of the source, and two common-source trench-type transistors may be subsequently formed after the wordline (gate structure) is formed.

A depth of the formed second groove 217 is less than that of the second isolation layer 211.

In this embodiment, when the active region 212 is etched to form the two second grooves 217distributed along the row direction in each active region 212, part of the insulating layer (the first isolation layer) 203 (referring to Figure 20) at a bottom of the opening 216 can be etched away at the same time, so that the formed second grooves 217 can extend into the insulating layer (the first isolation layer) 203 on both sides of the active region 212, and the depth of the second groove 217 formed in the insulating layer (the first isolation layer) 203is equal to or less than that of the second groove 217 formed in the active region 212.

In other embodiments, when the active region 212 is etched to form the two second grooves 217distributed along the row direction in each active region 212, the active region 212 is etched more than the insulating layer (the first isolation layer) 203, and when the second groove 217 is formed, the insulating layer at the bottom of the opening 216 will not be or will be little etched, so that the formed second groove 217 is only located in the active region 212.

In other embodiments, after formed, the two second grooves 217 divide each active region 212 into the source located in the middle and the two drains located on both sides of the source, with one of the two drains subsequently connected to the capacitor of the DRAM and the source connected to the bitline.

Referring to Figure 21 which is a three-dimensional schematic structural diagram of an active region and in which the anti-etching dielectric layer, the third mask pattern, or the like, on the top surface of the active region (the sources 220/219 and the drain 218) are not shown, a protective spacer 230 is formed on the sidewall of the second groove 217 before part of the insulating layer on both sides of the bottom of the second groove 217 is etched away to form, in the insulating layer 203, the third groove exposing part of the sidewall of the active region at the bottom of the second groove 217.

When part of the insulating layer 203 on both sides of the bottom is etched away subsequently, the protective spacer230 protects the sources 220/219 and the drain 218 on both sides of the sidewall of the second groove 217 from damage caused by etching and prevents a feature size of a window of the second groove 217 from being changed.

The protective spacer 230 and the insulating layer 203 are made from different materials, so that the protective spacer 230 is little etched when the insulating layer at the bottom of the second groove 217 is etched. In one embodiment, the protective spacer230is made of silicon nitride or/and silicon oxynitride, or any other suitable material.

In one embodiment, a formation process of the protective spacer 230 includes: forming a protective spacer material layer on the sidewall and bottom surface of the second groove 217; etching away the protective spacer material layer at the bottom of the second groove 217 without a mask to form the protective spacer 230 on the surface of the sidewall of the second groove 217.

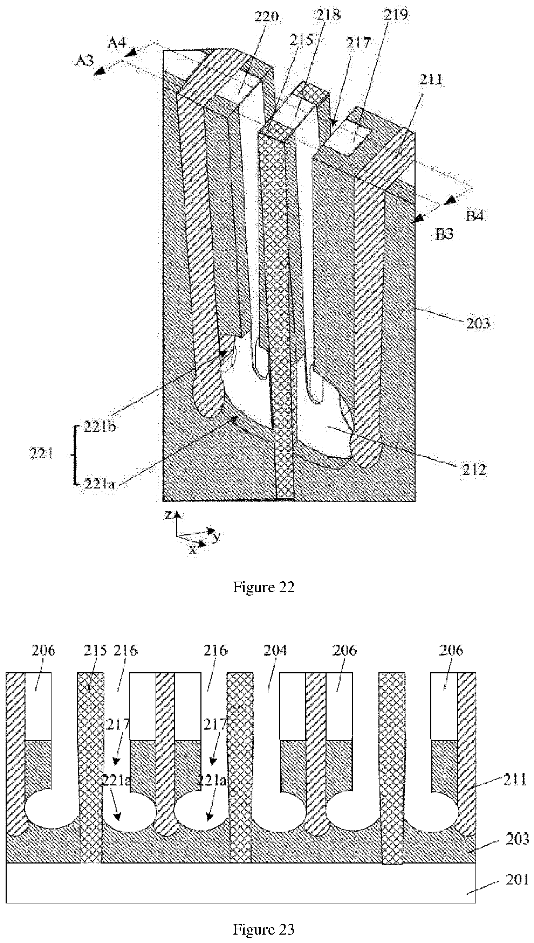

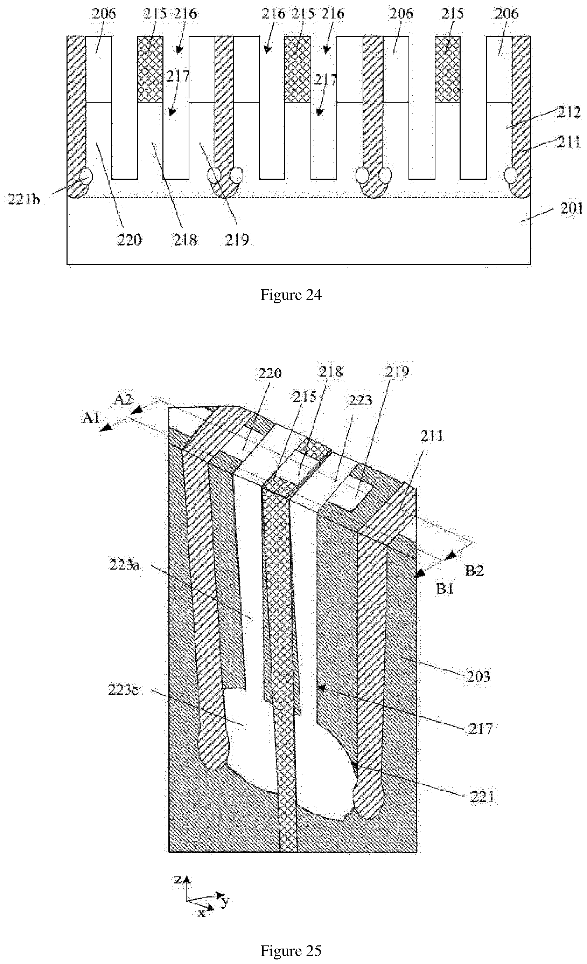

Referring to Figures 22 to 24 among which Figure 22 is based on Figure 21, Figure 23 is a schematic cross-sectional structural diagram taken along cutting line A3B3 in Figure 22 and Figure 24 is a schematic cross-sectional structural diagram taken along cutting line A4B4 in Figure 22, part of the insulating layer203 on both sides of the bottom of the second groove 217 is etched away to form, in the insulating layer 203, the third groove 221 which exposes at least part of the surfaces of the two sidewalls of the active region 212 at the bottom of the second groove 217, with the third groove 221 contact with the corresponding second groove 217 and with the two third grooves 221 adjacent in the row direction (the x-axis direction)not contacted.

An isotropic wet etching process may be used to etch away part of the insulating layer 203 on both sides of the bottom of the second groove 217. In the etching operation, the anti-etching dielectric layer 215 can prevent two adjacent second grooves 217 and two adjacent third grooves 221 from being contacted.

In this embodiment, in addition to exposing part of the surfaces of the two sidewalls of the active region 212 at the bottom of the second groove 217, the third groove 221 exposes part (position corresponding to the second isolation layer) of the surface of the sidewall of the second trench or the third trench, or part of the surface of one sidewall of the active region 212 apart from the second groove 217. Specifically, each active region has four sidewalls, including two opposite sidewalls in the x-axis direction (row direction) and two opposite sidewalls in the y-axis direction (column direction), and the third groove 221 includes a first portion 221a and a second portion 221b that are contacted to each other. The first portion 221a is located in the insulating layer 203 on both sides of the bottom of the second groove 217, and exposes part of the surfaces of the sidewalls (two opposite sidewalls in the y-axis direction (column direction)) of the active region 212at the bottom of the second groove 217; and the second portion 221 bis located between the active region 212and the second isolation layer 211, and exposes part of the surface of one sidewall (a sidewall in the x-axis direction (row direction)) of the active region 212apart from the second groove 217 and part of the surface of the second isolation layer 211. The second portion 221b is contact with the first portion 221a. With the third groove 221 structure, after formed in the third groove 221 and the second groove 217, the gate structure surrounds the peripheral sidewalls of the active region 212 (channel region) between the source 220 and the drain 218, which increases the area of the gate structure, improves the control of the gate structure over the channel region and further limits the leakage path of the leakage current between the polar plate of the capacitor (the capacitor is configured to store data and has one polar plate electrically connected to the source) and the semiconductor substrate, thereby more effectively reducing the leakage current, increasing the area of the wordline (the gate structure includes the wordline) and lowering the resistance value of the wordline.

In other embodiments, the third groove may only expose part of the surfaces of the two sidewalls (two opposite sidewalls in the y-axis direction (column direction)) of the active region 212 at the bottom of the second groove 217.With such a third groove structure, when formed in the third groove and the second groove 217 subsequently, the gate structure at least covers at least three side surfaces of the active region212 (channel region) between the source 220 and the drain 218, which increases the area of the gate structure, improves the control of the gate structure over the channel region and limits the leakage path of the leakage current between the polar plate of the capacitor (the capacitor is configured to store data and has one polar plate electrically connected to the source) and the semiconductor substrate, thereby effectively reducing the leakage current, increasing the area of the wordline (the gate structure includes the wordline) and lowering the resistance value of the wordline.

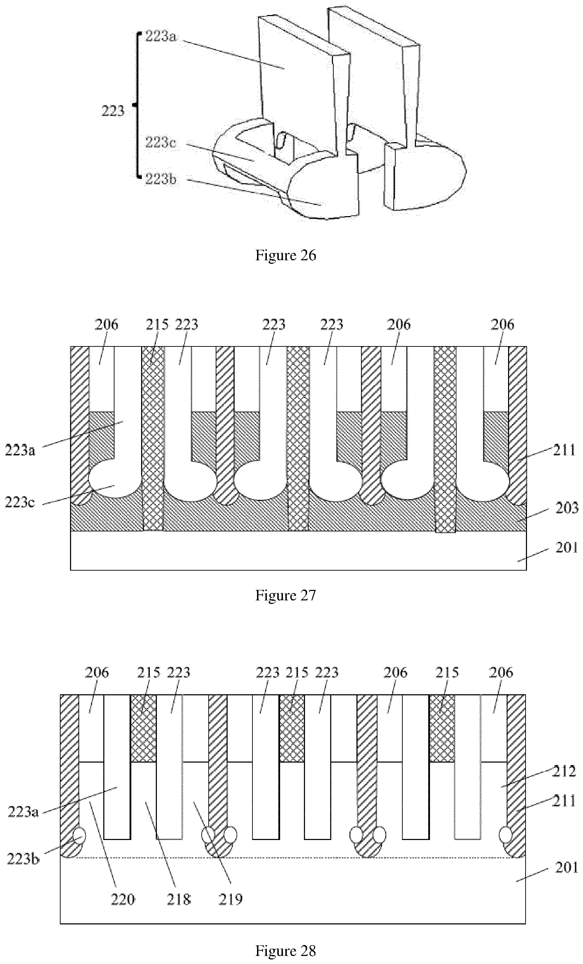

Referring to Figures 25 to 28 among which Figure 25 is based on Figure 22, Figure 26 is a three-dimensional schematic structural diagram of the gate structure, Figure 27 is a schematic cross-sectional structural diagram taken along cutting line A1B1 in Figure 25, and Figure 28 is a schematic cross-sectional structural diagram taken along cutting line A2B2 in Figure 25, a gate structure 223 is formed in the second groove and the third groove.

In one embodiment, the gate structure 223 is composed of a gate dielectric layer located on the surfaces of the sidewalls of the second groove and the third groove, and a gate located on the gate dielectric layer and filling the second groove and the third groove.

In one embodiment, the gate dielectric layer is made of a high-K dielectric material, such as HfO₂, TiO₂, HfZrO, HfSiNO, Ta₂O₅, ZrO₂, ZrSiO₂, Al₂O₃, SrTiO₃ or BaSrTiO. The wordline is made of one or more metal materials, such as W, Al, Cu, Ti, Ag, Au, Pt and Ni.

In other embodiments, the gate dielectric layer may be made of silicon oxide, and the wordline may be made of polysilicon.

In one embodiment, a formation process of the gate structure includes: forming a gate dielectric material layer on the surfaces of the sidewalls and bottoms of the third groove and the second groove; forming a gate material layer on the gate dielectric material layer; removing the gate dielectric material layer and the gate material layer higher than the top surfaces of the sources 220/219 and the drain 218, and forming the gate structure in the third groove and the second groove, with the gate structure including the gate dielectric layer located on the surfaces of the sidewalls of the second groove and the third groove and the gate located on the gate dielectric layer and filling the second groove and the third groove. In one embodiment, a chemical mechanical polishing process or an etch-back process may be used to remove the gate dielectric material layer and the gate material layer higher than the top surfaces of the sources 220/219 and the drain 218, and the third mask pattern 206 (referring to Figure 19), the anti-etching dielectric layer 215 and the second isolation layer 211 higher than the top surfaces of the sources 220/219 and the drain 218 can be removed while the gate dielectric material layer and the gate material layer higher than the top surfaces of the sources 220/219 and the drain 218 are removed.

Referring to Figure 26, the formed gate structure 223 is composed of a first portion 223a, a second portion 223b and a third portion 223c that are connected with one another, with the first portion 223afilled in the second groove 217(referring to Figure 22), the second portion 223b filled in the first portion 221a of the third groove 221 (referring to Figure 22) and the third portion 223c filled in the second portion 221b of the third groove 221 (referring to Figure 22).

In one embodiment, after the gate structure 223 is formed, the formation method of a memory structure also includes: forming the wordline connected to the gate; forming the capacitor (not shown) connected to the source 220 (or the source 219) on the insulating layer 203; and forming the bitline (not shown)connected to the drain 218 on the insulating layer 203.

Embodiments of the present invention also provide a memory structure which, referring to Figures 25 to 28, is composed of:
a semiconductor substrate 201, wherein a number of discrete active regions 212 arranged in rows and columns are formed on the semiconductor substrate 201, and a first groove is provided between the adjacent active regions and filled with an insulating layer (203 and 211);
two second grooves 217 along a row direction in each active region 212, wherein the two second grooves 217 divide each active region 212 into a drain 218 located in a middle of the active region and two sources 219/220 located on both sides of the drain;
a third groove221 located in part of the insulating layer(203 and 211) on both sides of a bottom of the second groove 217, wherein the third groove 221 exposes at least part of surfaces of both sidewalls of the active region 212 at the bottom of the second groove 217, and is contact with the corresponding second groove 217, and the two third grooves 217 adjacent in the row direction are not contacted; and
a gate structure 223located in the second groove 217 and the third groove 221.

In one embodiment, an anti-etching dielectric layer 215 is formed on the sidewalls of the active region between the two second grooves 217 and in the insulating layer (203 and 211), and the anti-etching dielectric layer 215 is made of a material different from that of the insulating layer 203.

A depth of the anti-etching dielectric layer 215 is greater than a total depth of the third groove 221 and the second groove 217; and a width of the anti-etching dielectric layer 215 in a column direction is greater than a width of the third groove 221 in the column direction

In one embodiment, a protective spacer is formed on the sidewall of the second groove 217.

In one embodiment, the first groove includes first trenches arranged in the column direction and second trenches arranged in the row direction, the first trench is filled with a first isolation layer 203, the second trench is filled with a second isolation layer 211, and the second isolation layer or a shallow trench isolation layer 211 and the first isolation layer 203 constitute the insulating layer.

In one embodiment, a third trench is further formed at a bottom of the second trench, a size of the third trench in the row direction is greater than a size of the second trench in the row direction, and the third trench and the second trench are filled with the second isolation layer or the shallow trench isolation layer.

In one embodiment, a depth of the second trench or a total depth of the second trench and the third trench is greater than the total depth of the second groove 217 and the third groove 221.

In this embodiment, in addition to exposing part of the surfaces of the two sidewalls of the active region at the bottom of the second groove 217, the third groove 221 exposes part of a surface of a sidewall of the second trench or the third trench, or part of the surface of one sidewall of the active region212 apart from the second groove.

In other embodiments, the third groove only exposes part of the surfaces of the two sidewalls of the active region at the bottom of the second groove.

In one embodiment, the gate structure 223includes: a gate dielectric layer located on the surfaces of the sidewalls of the second groove and the third groove; and a gate located on the gate dielectric layer and filling the second groove and the third groove.

Referring to Figure 26, the formed gate structure 223 is composed of a first portion 223a, a second portion 223band a third portion 223cthat are connected with one another, with the first portion 223a filled in the second groove 217(referring to Figure 22), the second portion 223b filled in the first portion 221a of the third groove 221(referring to Figure 22) and the third portion 223c filled in the second portion 221b of the third groove 221 (referring to Figure 22).

The memory structure further includes: a wordline connected to the gate; a capacitor (not shown) located on the insulating layer 203 and connected to the source 219 (or 220); and a bitline (not shown) located on the insulating layer 206 and connected to the drain 218.

It should be noted that other definitions or descriptions related to the memory structure in this embodiment will not be further explained. For details, please refer to the corresponding definitions or descriptions in the foregoing embodiments concerning formation process of memory structure.

Although the present invention has been disclosed as above in various embodiments, the present invention should not be limited by those embodiments. Those skilled in the art may make changes or modifications to the present invention based on the methods and technical solutions disclosed above without departing from the spirit and scope of the present invention. Therefore, any simple alterations, equivalent changes and modifications made to the foregoing embodiments based on the technical essence of the present invention without departing from the technical solutions proposed in the present invention are deemed to fall within the protection scope of the technical solutions in the present invention.

## Claims

1. A formation method of a memory structure, comprising:
providing a semiconductor substrate, on which a number of discrete active regions arranged in rows and columns are formed, a first groove being provided between the adjacent active regions and filled with an insulating layer;
etching the active regions to form two second grooves along a row direction in each active region, the two second grooves dividing each active region into a drain located in a middle of the active region and two sources located on both sides of the drain;
etching away part of the insulating layer on both sides of a bottom of the second groove to form a third groove in the insulating layer, a third groove exposing at least part of surfaces of both sidewalls of the active region at the bottom of the second groove, the third groove being contact with the corresponding second groove, and the two third grooves adjacent in the row direction being not contacted; and
forming a gate structure in the second groove and the third groove.

2. The formation method of a memory structure according to claim 1, wherein an anti-etching dielectric layer is formed on the sidewalls of the active region between the two second grooves and in the insulating layer, and the anti-etching dielectric layer is made of a material different from that of the insulating layer.

3. The formation method of a memory structure according to claim 2, wherein a depth of the anti-etching dielectric layer is greater than a total depth of the third groove and the second groove; and a width of the anti-etching dielectric layer in a column direction is greater than a width of the third groove in the column direction.

4. The formation method of a memory structure according to claim 2 or 3, wherein a formation process of the anti-etching dielectric layer comprises: forming a mask layer on the insulating layer and the active region, the mask layer comprising a number of openings along the row direction, and each opening exposing at least part of the surface of the insulating layer on both sides of the active region; etching the insulating layer along the openings by using the mask layer as a mask to form a fourth groove in the insulating layer, the fourth groove exposing part of the sidewall of the active region; and forming the anti-etching dielectric layer filling the fourth groove.

5. The formation method of a memory structure according to claim 1 or 2, wherein before the step of etching away part of the insulating layer on both sides of a bottom of the second groove to form a third groove in the insulating layer, a protective spacer is formed on the sidewall of the second groove.

6. The formation method of a memory structure according to claim 1 or 2, wherein the specific process of forming a number of discrete active regions arranged in rows and columns on the semiconductor substrate comprises: forming a number of discrete elongated active regions arranged in the column direction on the semiconductor substrate, a first trench being provided between adjacent elongated active regions and filled with a first isolation layer; etching the elongated active regions and the first isolation layer to form a number of second trenches arranged in the row direction in the elongated active regions and the first isolation layer, the second trench disconnecting the elongated active regions to form the number of discrete active regions arranged in rows and columns and the first groove being formed by the first trench and the second trench.

7. The formation method of a memory structure according to claim 6, wherein a second isolation layer filling the second trench is formed, and the insulating layer is formed by the first isolation layer and the second isolation layer.

8. The formation method of a memory structure according to claim 7, wherein the elongated active region and the first isolation layer at a bottom of the second trench are etched to form a third trench in the elongated active region and the first isolation layer at the bottom of the second trench before formation of the second isolation layer, and a size of the third trench in the row direction is greater than a size of the second trench in the row direction; the second isolation layer is formed in the third trench and the second trench.

9. The formation method of a memory structure according to claim 7, wherein a depth of the second trench or a total depth of the second trench and the third trench is greater than the total depth of the second groove and the third groove.

10. The formation method of a memory structure according to claim 1, wherein the third groove only exposes part of the surfaces of the two sidewalls of the active region at the bottom of the second groove.

11. The formation method of a memory structure according to claim 7, wherein in addition to exposing part of the surfaces of the two sidewalls of the active region at the bottom of the second groove, the third groove exposes part of a surface of a sidewall of the second trench or the third trench, or part of the surface of one sidewall of the active region apart from the second groove.

12. The formation method of a memory structure according to claim 1, wherein the gate structure is composed of: a gate dielectric layer located on the surfaces of the sidewalls of the second groove and the third groove; and a gate located on the gate dielectric layer and filling the second groove and the third groove.

13. The formation method of a memory structure according to claim 12, further comprising: forming a wordline connected to the gate; forming a capacitor connected to the source on the insulating layer; and forming a bitline connected to the drain on the insulating layer.

14. A memory structure, comprising:
a semiconductor substrate, wherein a number of discrete active regions arranged in rows and columns are formed on the semiconductor substrate, and a first groove is provided between the adjacent active regions and filled with an insulating layer;
two second grooves along a row direction in each active region, wherein the two second grooves divide each active region into a drain located in a middle of the active region and two sources located on both sides of the drain;
a third groove located in part of the insulating layer on both sides of a bottom of the second groove, wherein the third groove exposes at least part of surfaces of both sidewalls of the active region at the bottom of the second groove, and is contact with the corresponding second groove, and the two third grooves adjacent in the row direction are not contacted; and
a gate structure located in the second groove and the third groove.

15. The memory structure according to claim 14, wherein an anti-etching dielectric layer is formed on the sidewalls of the active region between the two second grooves and in the insulating layer, and the anti-etching dielectric layer is made of a material different from that of the insulating layer.

16. The memory structure according to claim 14, wherein a depth of the anti-etching dielectric layer is greater than a total depth of the third groove and the second groove, and a width of the anti-etching dielectric layer in the column direction is greater than a width of the third groove in the column direction.

17. The memory structure according to claim 14, wherein a protective spacer is formed on the sidewall of the second groove.

18. The memory structure according to claim 14, wherein the first groove comprises first trenches arranged in the column direction and second trenches arranged in the row direction, the first trench is filled with a first isolation layer, and the second trench is filled with a second isolation layer.

19. The memory structure according to claim 18, wherein a third trench is further formed at a bottom of the second trench, a size of the third trench in the row direction is greater than a size of the second trench in the row direction, and the third trench and the second trench are filled with the second isolation layer.

20. The memory structure according to claim 19, wherein a depth of the second trench or a total depth of the second trench and the third trench is greater than the total depth of the second groove and the third groove.

21. The memory structure according to claim 14 or 19, wherein the third groove only exposes part of the surfaces of the two sidewalls of the active region at the bottom of the second groove.

22. The memory structure according to claim 19, wherein in addition to exposing part of the surfaces of the two sidewalls of the active region at the bottom of the second groove, the third groove exposes part of a surface of a sidewall of the second trench or the third trench, or part of the surface of one sidewall of the active region apart from the second groove.

23. The formation method of a memory structure according to claim 14, wherein the gate structure comprises: a gate dielectric layer located on the surfaces of the sidewalls of the second groove and the third groove; and a gate located on the gate dielectric layer and filling the second groove and the third groove.

24. The memory structure according to claim 23, further comprising: a wordline connected to the gate; a capacitor located on the insulating layer and connected to the source; and a bitline located on the insulating layer and connected to the drain.
